# EUROPEAN PATENT SPECIFICATION

(11) **EP 0 690 349 B1**
(45) Date of publication and mention of the grant of the patent: **18.09.2002**
(21) Application number: 95304503.6
(22) Date of filing: 27.06.1995
(51) Int. Cl.: G03F 7/06, G03F 7/07, B41N 1/08

(54) **Image formation**
Bilderzeugung
Formation de l'image

(30) Priority: 30.06.1994 GB 9413197
(43) Date of publication of application: 03.01.1996
(73) Proprietor: AGFA-GEVAERT, 2640 Mortsel (BE)
(72) Inventor: Doyle, Stephen Bernard, Colton, Leeds LS15 9BL (GB); Gates, Allen Peter, Knaresborough HG5 8HU (GB); Kitteridge, John Michael, Leeds LS14 2DJ (GB); Watkiss, Philip John, Leeds LS16 5ND (GB); Evans, John Malcolm, Leeds, LS17 7SB (GB)

(56) References cited:
- EP-A- 0 519 123
- EP-A- 0 629 919
- WO-A-93/10979
- GB-A- 1 547 040
- US-A- 4 115 118
- RESEARCH DISCLOSURE, no. 182, June 1979 HAVANT GB, page 308 J.DS FOSTER ET AL. 'Plastic backed aluminium sheet and its use in lithography'

## Description

This invention relates to the formation of images directly from electronically composed digital sources and is concerned with the formation of images in this way using light sensitive coatings supported by substrates having an excellent combination of flexibility and lithographic properties. More especially, the present invention is concerned with the formation of images using silver halide based coatings supported by substrates which are laminates of aluminium and plastic.

For many years it has been a long term aim in the printing industry to form images directly from an electronically composed digital database, i.e. by a so called "computer-to-plate" system. The advantages of such a system over the traditional methods of making printing plates are:
(i) the elimination of costly intermediate film and processing chemicals;
(ii) a saving of time; and
(iii) the ability to automate the system with consequent reduction in labour costs.

The advent of imagesetters and phototypesetters has increasingly afforded the opportunity of forming an image directly on a printing plate precursor without the need for an intermediate film-making stage. Such devices are employed in order to output fully paginated text and graphic images at a high resolution; various techniques are employed for image creation, and these rely on computerised signals for their operation, and enable significant improvements to be achieved in terms of cost, efficiency and quality. The majority of the existing imagesetters and phototypesetters are, however, roll fed units designed for the exposure of film or paper rather than less flexible aluminium-based lithographic printing plates. Certain plastic-based printing plates, such as the Mitsubishi Silver Master, can be processed through imagesetters, but these plates have disadvantages of poor dimensional stability, making them unsuitable for full colour printing, and poor lithographic properties compared to conventional aluminium-based lithographic plates.

In general, it is found that plastic sheet, such as polyethylene terephthalate, has good flexibility, making it suitable for processing through imagesetters, but suffers from inadequate hydrophilicity, dimensional stability and coating adhesion for lithographic printing plate applications.

On the other hand, aluminium sheet, especially when grained and anodised, is suitable for almost all requirements for a supporting substrate of a presensitised lithographic printing plate, giving excellent hydrophilicity, dimensional stability and coating adhesion. Aluminium does, however, have the disadvantage of limited flexibility.

It is an object of the present invention to provide a lithographic printing plate precursor having the combination of desirable lithographic properties and excellent flexibility which will allow said precursor to be exposed in existing roll fed film and paper imagesetters and phototypesetters.

It is also an object of the present invention to provide a method of image formation by employing such a printing plate precursor in an imagesetter or phototypesetter.

Imagesetters are designed to be used with high speed silver halide film or paper. The well known comparatively high sensitivity to light of silver halides over conventional photopolymeric materials, and their ability to respond to light from ultra-violet to infra-red make them ideally suited for use in printing plate applications where direct-to-plate exposure, rather than exposure through a contact film intermediate, is called for.

It is a further object of the present invention to provide a printing plate precursor having a coating of sufficiently high speed to allow the printing plate precursor to be exposed in existing roll fed film and paper imagesetters and phototypesetters.

According to the present invention, there is provided a method of image formation which comprises:
(a) providing, in roll form, a printing plate precursor comprising
   (i) a base substrate comprising a laminate of aluminium and plastic, the thickness of the aluminium being in the range between 10 and 50 µm and the thickness of the plastic being in the range between 25 and 250 µm, and
   (ii) a photosensitive coating layer, applied to aluminium, containing silver halide;
(b) imagewise exposing the precursor by means of a roll fed imagesetter or phototypesetter so that the coating comprises radiation struck and non-radiation struck areas; and
(c) processing the imagewise exposed printing plate precursor to provide hydrophilic non-image areas and oleophilic image areas in accordance with the imagewise exposure.

The present invention envisages the use of a printing plate precursor comprising:
(a) a base substrate comprising a laminate of aluminium and plastic, and
(b) a photosensitive coating, applied to the aluminium, containing silver halide.

The present invention also comprehends the use of a printing plate precursor as hereinbefore defined in a method of image formation comprising imagewise exposing the precursor by means of an imagesetter or typesetter and processing in accordance with the method of the invention.

Composite sheets of aluminium and plastic *per se* are well documented in the prior art. They are described, for example, in European patents nos. 115,678 and 155,849 and European patent application publication no. 136,903. Laminates in which the aluminium is additionally grained and anodised are described, for example, in US patents nos. 4,065,364 and 4,680,250, and in Research Disclosure 18,219, June 1979, page 306. Previously, however, such substrates have not found widespread application in conventional film-based printing techniques, due to the higher cost of laminate in relation to aluminium. As previously noted, of course, substrates made solely from aluminium would be totally unsuitable for present purposes, due to their lack of flexibility.

The laminates of use in the present invention are preferably those in which aluminium is laminated to a plastic film by means of an adhesive. Such a material is disclosed, for example, in PCT patent application 93/10,979, which discloses a presensitised plate comprising a backing film of plastic material, preferably polyester resin, to which is bonded, via an adhesive material, a grained and anodised metallic (e.g. aluminium) foil, onto which is coated a photosensitive varnish.

For the purposes of the present invention, any conventional adhesive known in the art may be used, for example a polyurethane adhesive. The thickness of the adhesive layer lies in the range between 2 and 20 µm.

Suitable plastics for use in the laminate include polyethylene, polyamides and polyesters, but the preferred material, on the grounds of low cost and favourable physical properties, is polyethylene terephthalate (marketed as Mylar® by DuPont and Melinex® by ICI). The thickness of the plastic is, as stated, in the range from 25 to 250 µm, but is preferably in the range from 100 to 150 µm. A layer of antistatic material is optionally present on the back surface of the plastic.

For practical reasons, the thickness of the aluminium laminated to the plastic is between 10 and 50 µm; layers of greater than 50 µm thickness have insufficient flexibility, whereas problems with layer continuity can arise when layer thickness is less than 10 µm. The preferred range of aluminium thickness is between 20 and 30 µm. Various grades of aluminium may be used, for example 1200 grade (99.2% Al content) or 1050 grade (99.5% Al content). The aluminium may optionally be heat-treated in order to control hardness.

The aluminium is grained and anodised in order to render the surface sufficiently hydrophilic for lithographic printing and to ensure good adhesion between the substrate and the photosensitive coating. Various graining techniques are available, such as brush graining and chemical graining, but electrochemical graining in acid solution is preferred. Graining acids may include, for example, hydrochloric acid or nitric acid or, preferably, a mixture of hydrochloric acid and acetic acid. After graining, the aluminium is anodised in, for example, phosphoric acid or, more preferably, sulphuric acid. Optionally, the aluminium may also be cleaned prior to graining by treatment with, for example, sodium hydroxide, and prior to anodising by treatment with, for example, phosphoric acid.

It is preferred that, after graining and anodising, the aluminium substrate should comply with the specifications set out in European patent application no. 278,766, in terms of the relationship between the anodic weight and the surface roughness, as measured by the centre line average.

The laminate is coated with a high speed silver halide coating, and is thus capable of being converted into a printing plate. Silver halides, in the context of the present invention, may be used in a variety of ways. Suitable coatings include, for example, the single sheet diffusion transfer type, as described in European patent no. 131,462 and European patent application no. 278,766, in which a developer is applied to chemically develop exposed areas of a photosensitive coating, whilst at the same time physically developing the unexposed areas. In the unexposed areas soluble silver complexes diffuse to a nucleation layer where metallic silver is formed by reduction and can be made oleophilic for use as the printing image of a lithographic printing plate.

Tanning development type coatings, such as described in British patents nos. 1,547,040, 1,547,350, 1,567,844, 1,571,155 and 1,590,058, and which comprise a silver halide in combination with gelatin or other matrix binder, are also suitable for the purposes of the present invention. Such systems involve oxidised developing agent, which is generated on development of exposed silver halide, crosslinking the gelatin or other matrix binder, so providing a tough, ink-receptive image.

The possibility of utilising a support in which an aluminium sheet is laminated on a plastic film in combination with a silver halide emulsion is disclosed in US patent No. 4,115,118 which teaches the use of a more sophisticated tanning development system. This patent relates to a process for producing a printing plate which comprises imagewise exposing a light sensitive material comprising a support with a hydrophilic surface carrying a silver halide emulsion layer, developing said material with a non-tanning developer, fogging the previously unexposed silver halide by means of an overall exposure, developing said silver halide with a tanning developer whilst hardening said emulsion layer, and finally removing unhardened emulsion layer with hot water. Thus may be produced an oleophilic hardened relief image showing excellent continuous gradation reproduction. However, the processing stages required by the process of this citation are quite unsuited to the method of the present invention, which requires exposure by means of an imagesetter or phototypesetter.

Amongst other suitable coatings which can be employed in the present invention are coatings which employ a silver halide layer as a mask on top of a conventional photopolymerisable layer, such as described in British patents nos. 1,227,603, 2,052,084, 2,057,154 and 2,065,318, coatings which involve crosslinking of polymers on development, such as described in British patent no. 2,040,060 and European patent no. 52,942, and coatings which rely on silver halide initiation of polymerisation on development, such as described in US patents nos. 4,547,450, 4,859,568 and 4,879,201.

The lithographic printing plate comprising a silver halide-containing photosensitive layer coated on an aluminium/polyester laminate thus combines the sensitivity of silver halide systems and the advantageous printing properties of grained and anodised aluminium with the flexibility to be transported through standard imagesetters. The plate exhibits greater dimensional stability than a polyester-based plate and greater flexibility than an aluminium-based plate by virtue of the mid-point position of its Young's Modulus (Table 1).

**TABLE 1**

| **Substrate** | **Young's Modulus (GPa)** |
|---|---|
| Aluminium (Al) | 67 |
| Polyethylene terephthalate (PET) | 3.8 |
| Laminate (1 Al: 5 PET) | 16 |

It is the modulus of the laminated material which allows it to be transported by common imagesetters, for example the Linotype 300 and 500 series, whilst at the same time providing four times the strength exhibited by non-laminated polyester film. A further consequence of the increased strength is noted in the greater ease with which correct register may be achieved and maintained during colour printing.

Examples of commercial imagesetters which are compatible with the laminated plates of the invention, but not compatible with aluminium-based plates, are shown in Table 2.

**TABLE 2**

| **Manufacturer** | **Machine** | **Type** |
|---|---|---|
| Agfa | Compugraphic | Helium-Neon |
| | Selectset 500 | Helium-Neon |
| | Selectset 700 | Helium-Neon |
| Barco | BG3700 | Helium-Neon |
| | BG3800 | Helium-Neon |
| Crosfield | Studiowriter 650 | Argon Ion |
| | Studiowriter 1000 | Argon Ion |
| ECRM | Pellbox | Helium-Neon |
| Hell | Digiset | Argon Ion |
| Linotype | 300 | Helium-Neon |
| | 330 | Helium-Neon |
| | 500 | Helium-Neon |
| | 830 | Argon Ion |
| | 930 | Argon Ion |
| Monotype | Lasercomp | Helium-Neon |
| Optronics | Colorsetter 2000 | Argon Ion |
| | Colorsetter XL | Argon Ion |
| Purup | PE5000/7000 | Argon Ion |
| | PIM Blue | Argon Ion |
| Scitex | Dolev 200 | Helium-Neon |
| | Dolev 400 | Helium-Neon |
| | Dolev 800 | Helium-Neon |
| | ERAY | Argon Ion |
| | Raystar | Argon Ion |

The following examples are illustrative of the invention:

### Example 1

25 µm Aluminium foil (grade 1200) was laminated with a polyurethane adhesive to 125 µm Mylar® film. The aluminium surface was cleaned in sodium hydroxide solution, electrochemically grained in an electrolyte of hydrochloric and acetic acids by means of alternating current to give a CLA of 0.6 µm, cleaned in phosphoric acid solution, and anodised in sulphuric acid solution to give an anodic weight of 4.0 g/m².

The grained and anodised aluminium was coated with a thin layer of colloidal silver made by the Carey Lea method to give a coating weight of about 3.0 mg/m². This was followed by a coating of a light sensitive, high contrast, silver chlorobromide emulsion comprising 80 mole % chloride and 20 mole % bromide with a silver to gelatin ratio of 1:1. A merocyanine dye spectrally sensitising to 488 nm was included in the emulsion. The emulsion was cast onto the colloidal silver layer to give a coating weight of 4.0 g/m².

The laminate was imaged on a Purup PE5000 imagesetter, developed in developer A for 30 seconds at 25°C, the exposed areas were removed by scrubbing with water, and the plate was treated with finisher A.

| **Developer A** | |
|---|---|
| Sodium sulphite | 110 g |
| Hydroquinone | 20 g |
| Phenidone B | 6 g |
| Sodium hydroxide | 18.5 g |
| Sodium thiosulphate | 10 g |
| 2-Methylaminoethanol | 30 ml |
| Water | to 1 litre |

| **Finisher A** | |
|---|---|
| Borax | 4.77 g |
| 0.1M Hydrochloric acid | 200 ml |
| Trypsin | 10 g |
| Gum Arabic solution | 150 ml |
| Calcium nitrate | 0.5 g |
| Polyethylene glycol 200 | 100 ml |
| Phenylmercaptotetrazole | 2.0 g |
| Water | to 1 litre |

The laminate was placed on a Didde Glaser web offset press. 50,000 good copies were produced.

### Example 2

Example 1 was repeated except that a benzothiazole merocyanine dye, sensitising to 633 nm, was used. The laminate was exposed in a Linotype 330 imagesetter. Similar results were obtained.

### Example 3

Grained and anodised aluminium/Mylar® laminate, made as in Example 1, was coated with a silver chlorobromide emulsion, sensitised to 488 nm with a merocyanine dye, to give a coat weight of 2.0 g/m². The silver to gelatin ratio was 1:1.5. The emulsion was overcoated with a cresol-formaldehyde resin at a coat weight of 0.5 g/m².

The laminate was imaged on a Scitex Raystar imagesetter, developed for 1 minute at 25°C in developer B, and the unexposed areas were washed out in warm water.

| **Developer B** | |
|---|---|
| Pyrogallol | 3.0 g |
| Metol | 1.0 g |
| Sodium carbonate | 112.5 g |
| Potassium bromide | 1.5 g |
| Citric acid | 1.0 g |
| Sodium polymetaphosphate | 1.0 g |
| Water | to 1 litre |

The laminate was placed on a Rotaprint offset press. Satisfactory prints were obtained.

### Example 4

25 µm Aluminium foil was laminated to 125 µm Mylar® film. The laminate was cleaned in caustic soda solution, electrochemically grained in an electrolyte of hydrochloric and acetic acid by means of alternating current to give a CLA of 0.5 µm, anodised in a mixture of phosphoric and sulphuric acids to give an anodic weight of 3 g/m², and dipped in a 2% sodium metasilicate solution.

The laminated plate was coated with a mixture of a low gelatin silver iodobromide emulsion sensitised to 633 nm and an ammoniacal solution of a copolymer of ethyl acrylate (43%), methyl methacrylate (35%), methacrylic acid (10%), and 1-phenyl-3-methacrylamido-5-pyrazolone (12%) to give a coat weight of 1.5 g/m². The ratio of copolymer to silver was 1.5:1.

The laminated plate was imaged on a Linotype 500 imagesetter and developed for 60 seconds at 25°C in developer C.

| **Developer C** | |
|---|---|
| Potassium bromide | 0.1 g |
| Potassium carbonate | 54 g |
| Potassium hydrogen carbonate | 54 g |
| Hydroxylamine hydrochloride | 10 g |
| Sodium sulphite | 0.45 g |
| Hydroquinone | 10 g |
| 4-Hydroxymethyl-4-methyl-1-phenyl-3-pyrazolidone | 0.11 g |
| Water | to 1 litre |

The unexposed areas were removed by washing with water. The dried plate was placed on a Heidelberg SORM-Z sheet fed press. Excellent print quality was obtained.

## Claims

1. A method of image formation which comprises:
(a) providing, in roll form, a printing plate precursor comprising
(i) a base substrate comprising a laminate of aluminium and plastic, the thickness of the aluminium being in the range between 10 and 50 µm and the thickness of the plastic being in the range between 25 and 250 µm, and
(ii) a photosensitive coating layer, applied to aluminium, containing silver halide;
(b) imagewise exposing the precursor by means of a roll fed imagesetter or phototypesetter so that the coating comprises radiation struck and non-radiation struck areas; and
(c) processing the imagewise exposed printing plate precursor to provide hydrophilic non-image areas and oleophilic image areas in accordance with the imagewise exposure.

2. A method as claimed in claim 1 wherein the aluminium is grained and anodised.

3. A method as claimed in claim 1 or 2 wherein the aluminium is laminated to the plastic by means of an adhesive.

4. A method as claimed in any one of claims 1 to 3 wherein the plastic is polyethylene terephthalate.

5. A method as claimed in any one of claims 1 to 4 wherein the thickness of the aluminium is in the range between 20 and 30 µm.

6. A method as claimed in any one of claims 1 to 5 wherein the thickness of the plastic is in the range between 100 and 150 µm.

7. A method as claimed in any one of claims 1 to 6 wherein the photosensitive coating layer contains silver halide and a binder.

8. A method as claimed in any one of claims 1 to 7 wherein the imagesetter or phototypesetter is of the Helium-Neon or Argon Ion type.

## Patentansprüche

1. Bilderzeugungsverfahren mit den Schritten:
(a) Bereitstellen einer Druckplattenvorstufe in Rollenform bestehend aus
(i) einem Rohsubstrat, das ein Mehrschichtelement aus Aluminium und Kunststoff umfaßt, wobei die Stärke des Aluminiums im Bereich von 10 bis 50 µm liegt und die Stärke des Kunststoffes im Bereich von 25 bis 250 µm, und
(ii) einer auf das Aluminium aufgetragenen, silberhalogenidhaltigen, strahlungsempfindlichen Schicht;
(b) bildmäßiges Belichten der Vorstufe unter Verwendung eines Belichters oder Fotosetzgerätes mit Zuführung des Verarbeitungsgutes in Rollenform, so dass die Schicht von der Strahlung getroffene Bereiche und nicht von der Strahlung getroffene Bereiche umfaßt; und
(c) Entwickeln der bildmäßig belichteten Druckplattenvorstufe zur Bereitstellung wasserfreundlicher bildfreier Stellen und farbfreundlicher Bildstellen der bildmäßigen Belichtung entsprechend.

2. Verfahren nach Anspruch 1, **dadurch gekennzeichnet, dass** das Aluminium aufgerauht und eloxiert wurde.

3. Verfahren nach Anspruch 1 oder 2, **dadurch gekennzeichnet, dass** das Aluminium unter Verwendung eines Klebstoffes auf den Kunststoff kaschiert wird.

4. Verfahren nach einem der Ansprüche 1 oder 3, **dadurch gekennzeichnet, dass** es sich bei dem Kunststoff um Polyethylenterephthalat handelt.

5. Verfahren nach einem der Ansprüche 1 bis 4, **dadurch gekennzeichnet, dass** die Stärke des Aluminiums im Bereich von 20 bis 30 µm liegt.

6. Verfahren nach einem der Ansprüche 1 bis 5, **dadurch gekennzeichnet, dass** die Stärke des Kunststoffes im Bereich von 100 bis 150 µm liegt.

7. Verfahren nach einem der Ansprüche 1 bis 6, **dadurch gekennzeichnet, dass** die strahlungsempfindliche Schicht Silberhalogenid und ein Bindemittel enthält.

8. Verfahren nach einem der Ansprüche 1 bis 7, **dadurch gekennzeichnet, dass** der Belichter oder das Fotosetzgerät vom Helium-Neon-Typ oder vom Argon-Ionentyp ist.

## Revendications

1. Procédé de formation d'images comprenant les étapes consistant à
(a) procurer, sous forme de bobine, un précurseur de plaque d'impression comportant
(i) un support brut comprenant un stratifié d'aluminium et de matière plastique, l'épaisseur de l'aluminium variant entre 10 et 50 µm et l'épaisseur de la matière plastique variant entre 25 et 250 µm, et
(ii) une couche photosensible déposée sur l'aluminium et contenant de l'halogénure d'argent ;
(b) exposer le précurseur suivant une image au moyen d'une insoleuse ou d'une photocomposeuse alimentée par bobine, de manière que la couche comprenne des zones atteintes par le rayonnement et des zones non atteintes par le rayonnement ; et
(c) traiter le précurseur de plaque d'impression exposé suivant une image afin de procurer des zones hydrophiles exemptes d'image et des zones d'image oléophiles conformément à l'exposition suivant une image.

2. Procédé selon la revendication 1, **caractérisé en ce que** l'aluminium est grené et anodisé.

3. Procédé selon la revendication 1 ou 2, **caractérisé en ce que** l'aluminium est stratifié sur la matière plastique à l'aide d'une matière adhésive.

4. Procédé selon l'une quelconque des revendications 1 à 3, **caractérisé en ce que** la matière plastique est le polytéréphtalate d'éthylène.

5. Procédé selon l'une quelconque des revendications 1 à 4, **caractérisé en ce que** l'épaisseur de l'aluminium varie entre 20 et 30 µm.

6. Procédé selon l'une quelconque des revendications 1 à 5, **caractérisé en ce que** l'épaisseur de la matière plastique varie entre 100 et 150 µm.

7. Procédé selon l'une quelconque des revendications 1 à 6, **caractérisé en ce que** la couche photosensible contient de l'halogénure d'argent et un liant.

8. Procédé selon l'une quelconque des revendications 1 à 7, **caractérisé en ce que** l'insoleuse ou la photocomposeuse est du type à hélium et néon ou du type à argon ionisé.
